## Europäisches Patentamt
## European Patent Office
## Office européen des brevets

(19)

(11) Veröffentlichungsnummer: **0 441 810 B1**

(12)

# EUROPÄISCHE PATENTSCHRIFT

(45) Veröffentlichungstag der Patentschrift: **23.03.94**

(51) Int. Cl.$^5$: **G06F 15/60**

(21) Anmeldenummer: **89911775.8**

(22) Anmeldetag: **26.10.89**

(86) Internationale Anmeldenummer:
**PCT/DE89/00688**

(87) Internationale Veröffentlichungsnummer:
**WO 90/05344 (17.05.90 90/11)**

(54) **VERFAHREN ZUR PLAZIERUNG VON MODULEN AUF EINEM TRÄGER.**

(30) Priorität: **02.11.88 EP 88118251**

(43) Veröffentlichungstag der Anmeldung:
**21.08.91 Patentblatt 91/34**

(45) Bekanntmachung des Hinweises auf die
Patenterteilung:
**23.03.94 Patentblatt 94/12**

(84) Benannte Vertragsstaaten:
**AT BE DE FR GB IT NL**

(56) Entgegenhaltungen:
**EP-A- 0 133 466**

**25TH ACM/IEEE DESIGN AUTOMATION CON-
FERENCE, 12-15 JUNE 1988, ANAHEIM, PRO-
CEEDINGS 1988, PAPER 22.3, IEEE (US) R-S.
TSAY ET AL.: "PROUD: A FAST SEA-FO-GA-
TES PLACEMENT ALGORITHM", PAGES
318-323,**

(73) Patentinhaber: **SIEMENS AKTIENGESELL-
SCHAFT
Wittelsbacherplatz 2
D-80333 München(DE)**

(72) Erfinder: **ANTREICH, Kurt
Föhrenstrasse 1a
D-8034 Germering(DE)**
Erfinder: **JOHANNES, Frank
Edelweisstrasse 34
D-8034 Germering(DE)**
Erfinder: **KLEINHANS, Jürgen
Kieferngartenstrasse 41
D-8000 München 45(DE)**
Erfinder: **SIGL, Georg
Alpspitzweg 4
D-8132 Tutzing(DE)**

Rank Xerox (UK) Business Services
(3.10/3.09/3.3.3)

PROCEEDINGS VLSI AND COMPUTERS, FIRST INTERNATIONAL CONFERENCE ON COMPUTER TECHNOLOGY, SYSTEMS AND APPLICATIONS, 11-15 MAY 1987, HAMBURG IEEE (US) D.L. JARMON: "AN AUTOMATIC PLACER FOR ARBITRARY SIZED RECTANGU-LAR BLOCKS BASED ON A CELLULAR MO-DEL", PAGES 466-470

PROCEEDINGS VLSI AND COMPUTERS, FIRST INTERNATIONAL CONFERENCE ON COMPUTER TECHNOLOGY, SYSTEMS AND APPLICATIONS, 11-15 MAY 1987, HAMBURG IEEE (US) H. CAI ET AL.: "AN AUTOMA-TIC/INTERACTIVE PLACEMENT AND ROU-TING SYSTEM FOR CUSTOMVLSI LAYOUT DESIGN", PAGES 625-628

IEEE INTERNATIONAL CONFERENCE ON COMPUTER-AIDED DESGN, 7-10 NOVEMBER 1988, SANTA CLARA, IEEE (US) J.M. KLEIN-HANS ET AL.: "GORDIAN: A NEW GOBAL OPTIMIZATION/RECTANGLE DISSECTION ME-THOD FOR CELL PLACEMENT", PAGES 506-509

EP 0 441 810 B1

**Beschreibung**

Die Erfindung bezieht sich auf ein Verfahren zur Plazierung von Modulen auf einem Träger unter Verwendung von einer die Abmessungen der Module enthaltenden Modulliste und einer die Verbindungen der Module enthaltenden Netzliste.

Verfahren zur Plazierung von Modulen auf einem Träger z.B. von Gate-Arrays, Standardzellen, Makrozellen auf einem Chip oder von Bausteinen auf Leiterplatten, sind bekannt. Als Beispiele für den Stand der Technik wird hingewiesen auf Cheng, C.-K., Kuh, E.S.: Module placement based on resistive network optimization, IEEE Transactions on Computer-Aided Design, Band CAD-3, 1984, S. 218-225; Just, K.M., KLeinhans, J.M., Johannes, F.M., On the relative placement and the transportation problem for standard-cell layout, Design Automation Conference, 1986, S. 308-313. In diesen Literaturstellen sind Verfahren angegeben, mit deren Hilfe Module in ihrer relativen Lage zueinander zunächst auf dem Träger plaziert werden und dann ihre endgültige Lage auf dem Träger zugewiesen bekommen. Ausgangspunkt ist die Topologie der Schaltung, also z.B. ein Stromlaufplan, aus dem sich ergibt, wie eine Anzahl von Modulen miteinander verbunden sind. Aufgabe der Plazierung ist es dann, diese Module unter Berücksichtigung ihrer Verbindungen optimal auf einem Träger, z.B. einem Chip, anzuordnen. Das Plazierungsverfahren ist ausführlich in den genannten Literaturstellen beschrieben, auf die verwiesen wird.

Die bekannten Verfahren streben zunächst eine Relativplazierung der Module zueinander an. Dazu werden die Koordinaten der einzelnen Module so berechnet, daß der Schwerpunkt der Module in einem vorgegebenen Punkt, z.B. den Zentrumskoordinaten der für die Anordnung vorgesehenen Fläche der Plazierungsfläche, liegen. Die Koordinaten der Module werden durch Lösen eines Optimierungsproblems ermittelt, bei dem eine Funktion der Abstände der miteinander verbundenen Module zu einem Minimum gemacht wird. Die Lösung dieses Optimierungsproblems erfolgt unter Berücksichtigung von Nebenbedingungen, durch die erreicht wird, daß die Module möglichst gleichverteilt auf der Plazierungsfläche liegen. Die Bestimmung der endgültigen und überlappungsfreien Lage der Module erfolgt nach Abschluß der relativen Plazierung. Dabei wird die Information der Relativplazierung genutzt.

Die der Erfindung zugrundeliegende Aufgabe besteht darin, ein weiteres Verfahren zur Plazierung von vorgefertigten Modulen auf einem Träger anzugeben.

Diese Aufgabe wird bei einem Verfahren der eingangs angegebenen Art gemäß Patentanspruch 1 gelöst.

Das Verfahren besteht somit aus einer Wiederholung einer Globalplazierung der Module auf einem Plazierungsgebiet und nachfolgender Partitionierung, wobei diese Schritte solange wiederholt werden, bis jedes durch Aufteilung festgelegte Teilgebiet höchstens eine vorgegebene Anzahl von Modulen enthält. Die Globalplazierung erfolgt durch Anordnung der Module in den Teilgebieten derart, daß die den Teilgebieten zugewiesenen Module mit ihren Schwerpunkten auf die Zentrums-Koordinaten dieser Teilgebiete fallen. Im Unterschied zu den bekannten Verfahren wird hierbei die Anordnung aller Moduln aller Teilgebiete simultan berechnet. Die Teilgebiete werden durch Partitionierung des Plazierungsgebietes bzw. von Teilgebieten erreicht, wobei den durch die Partitionierung erreich ten Teilgebieten eine wählbare Anzahl von Modulen zugeordnet werden und die Größe der durch die Partitionierung erreichten Teilgebiete in Abhängigkeit der zugewiesenen Module festgelegt wird.

Die Unterteilung des Plazierungsgebietes bzw. der Teilgebiete erfolgt zweckmäßigerweise durch horizontale oder vertikale Schnittlinien. Für die Zuweisung der Module zu den Teilgebieten ist dann lediglich eine Sortierung der Module nach ihren x- bzw. y-Koordinaten aus der vorherigen Globalplazierung erforderlich. Zweckmäßig ist es, wenn die Partitionierung aus einer Zweiteilung der aufzuteilenden Gebiete besteht.

Die Wiederholung von Globalplazierung und Partitionierung kann solange fortgeführt werden, bis in jedem Teilgebiet nur noch ein Modul angeordnet ist. Vorteilhafter ist es jedoch, wenn diese Wiederholung abgebrochen wird, wenn in jedem Teilgebiet höchstens eine vorgegebene Anzahl von Modulen, z.B. 8 Module, enthalten sind. Dann kann mit einem Optimierungsschritt die endgültige Anordnung der Module unter optimaler Flächenausnutzung auf dem Plazierungsgebiet durchgeführt werden. Dieser Schritt kann darin bestehen, daß alle möglichen Zerteilungen der Teilgebiete mit bis zu k Modulen unter Ausnutzung des Ergebnisses der Globalplazierung festgestellt werden und die dabei gefundenen Abmessungen der Teilflächen für die Plazierung eines Bausteins in einer Formfunktion zusammengefaßt werden. Dieser Schritt kann für alle derartigen Teilgebiete durchgeführt werden. Durch Addition der Formfunktionen dieser Teilgebiete können die Abmessungen aller erlaubten Modulanordnungen berechnet werden.

Andere Weiterbildungen der Erfindung ergeben sich aus den Unteransprüchen.

Das erfindungsgemäße Verfahren hat den Vorteil, daß Module verschiedener Abmessungen überlappungsfrei in einer Ebene angeordnet werden können, wobei Vorgaben für die Orte eines Teils der Module

3

berücksichtigt werden. Das Verfahren optimiert die Anordnung bezüglich einer Funktion der Abstände zwischen gegebenen Gruppen von Modulen und bezüglich der Gesamtfläche der Modulanordnung.

Das Verfahren dient insbesondere dem Zweck, die Plazierung der Module (Zellen, Bausteine) beim Layout-Entwurf elektrischer Schaltungen, d.h. die Umsetzung einer gegebenen Funktionsbeschreibung der Schaltung in eine ebene örtliche Anordnung durchzuführen. Dabei sind die Abmessungen der Module in einer Modulliste spezifiziert. Die Funktionsbeschreibung ist als Netzliste gegeben, in der alle Modulgruppen angegeben sind, die bei der Minimierung der Modulabstände berücksichtigt werden sollen.

Das Verfahren ist sowohl für den Layout-Entwurf integrierter Zellenschaltungen in Standardzellen-, Makrozellen-, Gate-Array- und Sea of Gates Technologie als auch für die Plazierung von Bausteinen auf Leiterplatten geeignet.

Anhand eines Ausführungsbeispiels, das in den Figuren dargestellt ist, wird die Erfindung weiter erläutert. Es zeigen

Figur 1 ein Beispiel für einen Stromlaufplan,

Figur 2 die Anordnung von Modulen im Plazierungsgebiet beim ersten Durchgang,

Figur 3 das Plazierungsgebiet mit Anordnung der Module bei einem zweiten Durchgang,

Figur 4 dasselbe nach einem dritten Durchgang,

Figur 5 die endgültige Plazierung der Module auf dem Plazierungsgebiet,

Figur 6 eine Erläuterung der X-,Y-Koordinaten eines Moduls,

Figur 7 ein Ablaufdiagramm des Verfahrens.

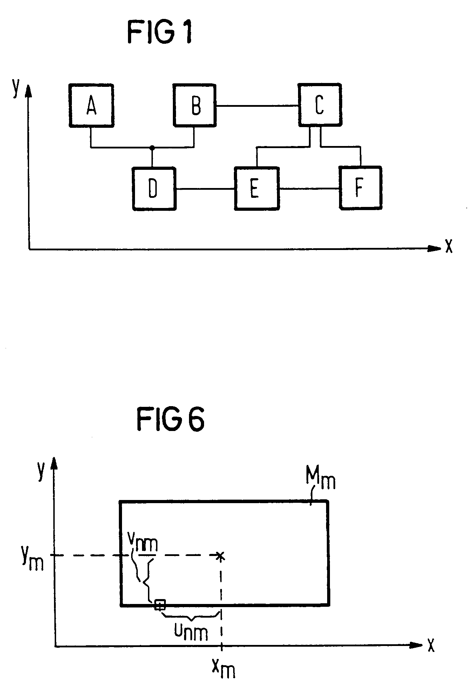

Das Problem, das mit dem Verfahren gelöst werden soll, kann darin bestehen, einen Stromlaufplan, wie er z.B. in Figur 1 gezeigt ist, in ein Layout der Schaltung z.B. auf einem Chip umzuwandeln. Figur 1 zeigt lediglich ein Prinzipbild eines Stromlaufplans mit wenigen Modulen. Die Module sind mit großen Buchstaben gekennzeichnet. Sie können z.B. Zellen einer Zellenbibliothek darstellen. Die einzelnen Module sind miteinander verbunden, wobei in Figur 1 die Verbindungen vereinfacht dargestellt sind. Die Verbindungen der Module werden auch Signale genannt.

Die Abmessungen der Module sind in einer Modulliste und die Verbindungen der Module in einer Netzliste enthalten. Die Modulliste und die Netzliste sind vorgegeben und werden zur Plazierung der Module auf einem Träger, z.B. einem Chip, verwendet.

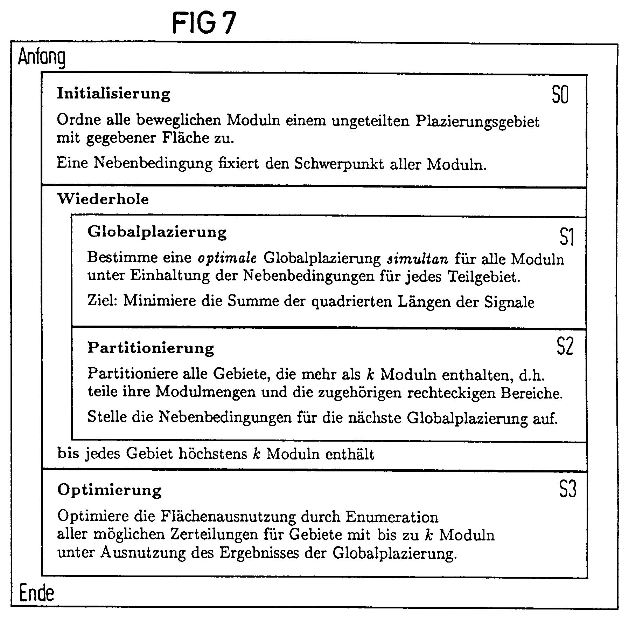

Die Plazierung der Module erfolgt entsprechend dem Ablaufdiagramm der Figur 7. Es ist zu sehen, daß das Verfahren aus einer Folge abwechselnder Schritte S, nämlich Globalplazierungen S1 und Partitionierungen S2 besteht. Die Folge endet, wenn jede durch die Partitionierungen entstandene Teilmenge von Moduln nicht mehr als eine vorgebbare Anzahl von Moduln enthält. Das Verfahren kann zweckmäßigerweise durch einen Optimierungsschritt S3 abgeschlossen werden, bei dem die Flächenausnutzung in den entstandenen Teilgebieten des Plazierungsgebietes durch Auswerten aller möglichen Modulanordnungen verbessert wird, wobei neben den Koordinaten der Moduln auch deren Drehlage bestimmt wird.

Mit der Globalplazierung wird erreicht, daß aus der funktionalen Schaltungsbeschreibung durch Formulieren und Lösen eines kontinuierlichen Optimierungsproblems mit Nebenbedingungen eine global optimale Modulanordnung, d.h. optimale örtliche Nachbarschaften für alle Moduln, berechnet wird. Dabei werden alle Module bis zum Erreichen einer überlappungsfreien Anordnung simultan behandelt.

Im einleitenden Verfahrensschritt SO werden alle Module $M_b$ einer ungeteilten Menge zugeordnet. Gegeben ist dabei die Netzliste, d.h. die Liste aller möglicherweise gewichteten Modulgruppen (Netze), für die die Abstandsfunktion zu minimieren ist. Gegeben sind in der Modulliste ferner die Abmaße und Anschlußkoordinaten aller Moduln M, die geometrischen Orte von Moduln mit vorgegebener Lage (fixierte Moduln) sowie ein Plazierungsgebiet. Außerdem sind gegebene Nebenbedingungen einzuhalten.

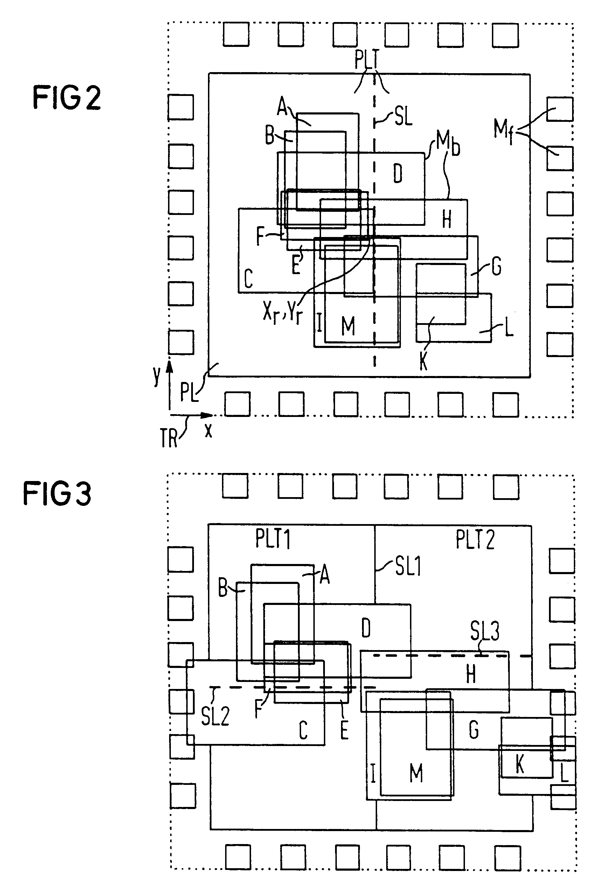

In Figur 2 ist das Plazierungsgebiet mit PL bezeichnet, das z.B. Teil eines Trägers TR sein kann. Auf dem Plazierungsgebiet PL sind Module M anzuordnen. Die Module können beweglich sein, oder sie können eine fixierte Lage haben. Bewegliche Module sind mit $M_b$ bezeichnet, fixierte Module mit $M_f$. Figur 2 stellt z.B. einen Chip dar, der am Rand als fixierte Module $M_f$ Anschlüsse (Pads) und im Plazierungsgebiet PL bewegliche Module $M_b$, z.B. Zellen aufweist. Die beweglichen Module $M_b$ sind mit großen Buchstaben bezeichnet.

Aus der Modulliste und der Netzliste werden die geometrischen Orte für alle nicht vorplazierten Module $M_b$ berechnet. Dieses Problem ist bekannt und z.B. in den eingangs angegebenen Literaturstellen dargestellt. Das Problem ist durch das folgende mathematische Modell beschrieben: Bestimme die unbekannten Koordinaten der Vektoren x und y derart, daß

$$\phi(x,y) = \frac{1}{2} \sum_{n \in N} \sum_{m \in M} \left( (x_m + u_{nm} - x_n)^2 + (y_m + v_{nm} - y_n)^2 \right) \cdot t_{nm} \cdot w_n \qquad (1)$$

minimal wird und für jedes der r Plazierungsgebiete oder Teilgebiete PLT die Nebenbedingungen

$$\left(\sum_{m \in M_r} F_m \cdot x_m\right) \bigg/ \left(\sum_{m \in M_r} F_m\right) = X_r \quad \text{und}$$

$$\left(\sum_{m \in M_r} F_m \cdot y_m\right) \bigg/ \left(\sum_{m \in M_r} F_m\right) = Y_r \tag{2}$$

für $1 \leq r \leq R$ eingehalten werden.

Die verwendeten Formelzeichen haben folgende Bedeutung:

| | |
|---|---|
| $m$ | Modulnummer |
| $n$ | Netznummer |
| $M = (...,m,...)$ | Menge der Modulnummern |
| $N = (...,n,...)$ | Menge der Netznummern |
| $M_b \subset M$ | Menge der beweglichen Moduln |
| $M_f \subset M$ | Menge der fixierten Moduln |
| $b$ | Anzahl der beweglichen Moduln |
| $f$ | Anzahl der fixierten Moduln |
| $x = (...x_n...x_m...)$ | Vektor der x-Koordinaten aller Netze und Moduln |
| $y = (...y_n...y_m...)$ | Vektor der y-Koordinaten aller Netze und Moduln |
| $u_{nm}$ | x-Koordinate des Anschlusses des Netzes n am Modul m |
| $v_{nm}$ | y-Koordinate des Anschlusses des Netzes n am Modul m |

$$t_{nm} = \begin{matrix} 1 \\ 0 \end{matrix}$$

falls Netz n am Modul m angeschlossen ist falls nicht angeschlossen

| | |
|---|---|
| $w_n$ | Gewichtsfaktor des Netzes n |
| $F_m$ | Flächenbedarf des Moduls m |
| $r$ | Nummer des Plazierungsgebiets PL oder eines Teilgebietes PLT |
| $M_r \subset M_b$ | Menge der Moduln, auf die die Nebenbedingung r angewandt wird |
| $X_r, Y_r$ | Zentrumskoordinaten des r-ten Plazierungsgebiets PL, PLT |
| $R$ | Anzahl der Teilgebiete PLT |

In der Formel 1 sind die Abstände eines Moduls von den angeschlossenen Netzen, also $x_m-x_n$, $y_m-y_n$, enthalten, wobei durch $u_{nm}$, $v_{nm}$ noch berücksichtigt wird, daß die Netze nicht zum Zentrum des Moduls, sondern zu seinen Anschlußpunkten führen. Dies kann z.B. Figur 6 entnommen werden, in dem ein Modul $M_m$ im Koordinatensystem dargestellt ist. Das Zentrum des Moduls wird durch die x-, y-Koordinate festgelegt, die Lage des Anschlusses eines Moduls durch die auf den Modulmittelpunkt bezogenen Koordinaten u, v. Da die Verbindungen zu den Anschlüssen der Module führen, muß der Abstand zwischen den Zentrumskoordinaten der Module entsprechend korrigiert werden.

Durch den Gewichtsfaktor w kann die Bedeutung eines Netzes festgelegt werden. Mit Hilfe von t wird angegeben, ob ein Netz an einem Modul angeschlossen ist oder nicht.

Für den Layout-Entwurf kann es vorteilhaft sein, die Orte der sog. Anschlüsse (Pads) am Rand des Plazierungsgebietes PL nicht fest vorzugeben, sondern sie einem der vier Ränder zuzuordnen und für linke oder rechte Anschlüsse deren y-Koordinate und für obere und für untere Anschlüsse deren x-Koordinate zu berechnen.

Mit Hilfe des Gleichungssystems 1 werden die Koordinaten der Module berechnet. Anschaulich kann dieses System auch interpretiert werden als ein System von Massenpunkten, die durch elastische Federn mit Federkonstanten verbunden sind. Die Federkonstante entspricht dabei der Wichtigkeit des Netzes, das mit den betrachteten Modul verbunden ist.

Die Lösung des Gleichungssystem 1 führt somit zur Berechnung der Koordinaten aller Module $M_b$. Ihr Schwerpunkt muß nun einem bestimmten Punkt des Plazierungsgebietes PL zugewiesen werden. Aus diesem Grunde wird eine Nebenbedingung, Formel 2, aufgestellt, die die Zentrumskoordinaten $X_r, Y_r$ des

Plazierungsgebietes PL angibt. Wenn die Lösung des Gleichungssystems 1 unter Beachtung der Nebenbedingung 2 erfolgt, dann wird der Schwerpunkt der Module auf diese Zentrumskoordinaten gelegt.

Aus Figur 2 ergibt sich die Lage der beweglichen Module $M_b$ innerhalb des Plazierungsgebietes PL. Die Module sind um die Zentrumskoordinaten $X_r, Y_r$ angeordnet.

Ausführlichere Erläuterungen zur Lösung des Gleichungssystems 1 unter Beachtung der Nebenbedingung 2 für ein Plazierungsgebiet PL kann der eingangs zitierten Literaturstelle Just entnommen werden. Die verwendete Problemformulierung stellt wegen der Konvexität der Zielfunktion auch bei Vorliegen mehrerer linearer Nebenbedingungen 2 sicher, daß ein eindeutiges globales Optimum existiert. Die Lösung kann effizient mit Hilfe bekannter Algorithmen zur Bearbeitung von Problemen der quadratischen Optimierung gewonnen werden, wie sie z.B. in Gill, P.E., Murray, W., Wright, M.H., Practical Optimization, Academic Press, London, 1981 beschrieben sind.

Nach Figur 7 folgt auf den Schritt S1, bei dem die Module auf dem Plazierungsgebiet PL in Abhängigkeit der Formel 1, 2 plaziert worden sind, der Schritt S2. Nun wird das Plazierungsgebiet PL aufgeteilt (angedeutet durch die Schnittlinie SL in (Fig. 2). Im Partitionierungsschritt wird also das Gebiet, in dem ein Modul angeordnet werden kann, immer weiter eingeschränkt. Die Folge der wiederholten Partitionierungsschritte führt am Verfahrensende zu einer vollständigen Zerlegung der Plazierungsfläche in eben soviele Rechtecke wie Moduln zu plazieren sind und damit zu einer zulässigen Plazierung. Diese unterscheidet sich von den temporären Globalplazierungen dadurch, daß die Moduln überlappungsfrei und gemäß den Regeln des zugehörigen Entwurfsstils angeordnet sind.

Ein Plazierungsgebiet PL, PLT ist beschrieben durch Breite, Höhe, Fläche, Zentrumskoordinaten und die Menge der Moduln, die in diesem Gebiet plaziert werden sollen.

Wenn der Schritt S2 zum ersten Mal ausgeführt wird, wird mit dem Plazierungsgebiet PL begonnen, das ist die gesamte Plazierungsfläche, und mit der in diesem Plazierungsgebiet angeordneten Menge aller beweglichen Moduln $M_b$. Die Partitionierung besteht nun aus zwei Unterschritten:

1. Die Modulmenge $M_b$ wird in Untermengen geteilt. Die Teilung erfolgt aufgrund der beim Globalplazierungsschritt berechneten Modulkoordinaten x, y, die ein Minimum bezüglich Netzlängen darstellen. Dies wird bei einer horizontalen bzw. vertikalen Schnittlinie SL durch Sortieren nach y- bzw. x- Koordinaten der Moduln und entsprechender Teilung in zwei oder mehr Teilmengen erreicht. Wenn die Zerlegung bezüglich der Anzahl der von der Schnittlinie SL geschnittenen Netze bestimmt werden soll, ist auch eine zusätzliche Anwendung des Min-Cut-Prinzips auf Moduln in der Nähe der Schnittlinie möglich. Das Min-Cut-Prinzip ist z.B. in Lauther, U., A min-cut placement algorithm for general cell assemblies based on a graph representation, in Design Automation Conference, 1979, S. 1- 10 beschrieben.

Im Ausführungsbeispiel der Figur 2 erfolgt eine Zweiteilung durch eine Schnittlinie SL1 und zwar in vertikaler Richtung.

In diesem Fall ist es zweckmäßig, jedem durch die Zweiteilung erreichten Teilgebiet PLT eine möglichst gleiche Anzahl von Moduln zuzuordnen. Die Zuordnung der Module zu den Teilgebieten PLT kann im Ausführungsbeispiel der Figur 2 nach x-Koordinaten der Module erfolgen, z.B. können die Module mit niedriger x-Koordinate dem linken Teilgebiet und Module mit höherer x-Koordinate dem rechten Teilgebiet zugewiesen werden.

2. Das Plazierungsgebiet PL wird in nicht überlappende Teilgebiete PLT zerlegt, die das Plazierungsgebiet vollständig und im Verhältnis der Flächen der zugehörigen Moduluntermengen überdecken. Dies führt gewöhnlich dazu, daß die gestrichelte Linie SL in Figur 2 zu verschieben ist. Im Fall eines horizontalen Schnitts werden die Höhen $h_{r'}$ und $h_{r''}$ der Teilgebiete wie folgt gewählt:

$$\frac{h_{r'}}{h_{r''}} = \sum_{m' \in M_{r'}} F_{m'} \bigg/ \sum_{m'' \in M_{r''}} F_{m''} \qquad (3)$$

Dabei ist $F_{m'}$ die Fläche eines Moduls m' in einem Teilgebiet r', $F_{m''}$ die eines Moduls m'' im anderen Teilgebiet r''. Die durch diesen Partitionierungsschritt erzeugte Zerlegung des Plazierungsgebietes PL in Teilgebiete PLT ergibt eine sog. Slicing Struktur, die Voraussetzung für die später beschriebene Flächenoptimierung ist und die sich beim Layout-Entwurf besonders gut für die spätere Konstruktion der Verbindungsnetze eignet.

Nach Durchführung des Schrittes S2 wird wiederum der Globalplazierungsschritt S1 ausgeführt. Das heißt das Gleichungssystem 1 wird neu berechnet, jetzt aber unter Berücksichtigung neuer Nebenbedingungen, und zwar Nebenbedingungen für jedes Teilgebiet PLT. Das heißt die Zentrumskoordinaten $X_r$ und $Y_r$

sind nun bezogen auf die durch den Schnitt des Plazierungsgebietes erreichten Teilgebiete PLT. Im Ausführungsbeispiel wären zwei Teilgebiete, so daß nun zwei Nebenbedingungen bei der Berechnung des Gleichungssystems 1 einzuhalten sind. Die Berechnung des Gleichungssystems 1 erfolgt simultan für alle Moduln und wird nicht getrennt für jedes Teilgebiet PLT durchgeführt. Das Ergebnis des Schrittes S1, Globalplazierung, zeigt Figur 3. Es ist zu sehen, daß nunmehr ein Teil der Module dem linken Teilgebiet PLT 1, ein Teil dem rechten Teilgebiet PLT 2 zugeordnet sind. Innerhalb jedes Teilgebietes PLT sind die zugewiesenen Module um deren Zentrumskoordinaten herum gruppiert. Anhand der Buchstaben der Module ist zu erkennen, wie die einzelnen Module sich schwerpunktsmäßig vom Ausgangspunkt der Figur 2 in die Teilgebiete PLT verschoben haben.

Auf den Globalplazierungsschritt S1 folgt wieder ein Partitionierungsschritt S2 nach den Regeln, die oben beschrieben worden sind. Dazu wird jedes Teilgebiet PLT 1, PLT 2 jeweils durch eine Schnittlinie SL2, SL3 unterteilt und den neu gewonnenen Teilgebieten werden in Abhängigkeit der bei der Globalplazierung gewonnenen Koordinaten die einzelnen Module zugewiesen. Die Größe der Flächen der Teilgebiete wird wiederum im Verhältnis der Flächen der diesen Teilgebieten zugewiesenen Module festgelegt.

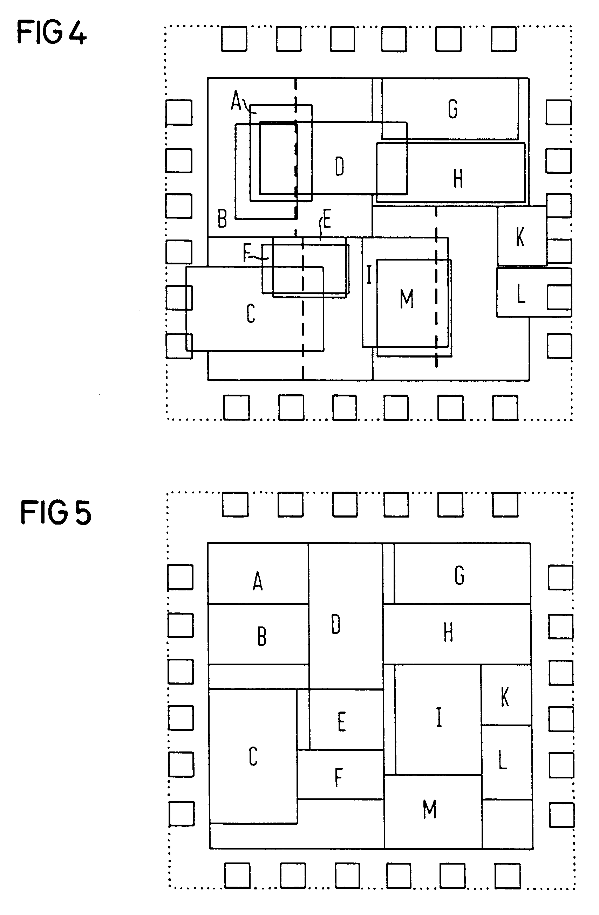

Auf den Schritt S2 folgt wiederum der Globalplazierungsschritt S1, d.h. das Gleichungssystem 1 wird nunmehr unter Berücksichtigung der neuen Nebenbedingungen gelöst. Bei einer jeweiligen Zweiteilung der bisherigen Teilgebiete sind nunmehr vier Nebenbedingungen einzuhalten. Das Ergebnis dieser Berechnung zeigt Figur 4. Anschließend an die Globalplazierung erfolgt wiederum eine Partitionierung, Schritt S2.

Die Schritte Globalplazierung S1 und Partitionierung S2 werden solange wiederholt bis entweder für jedes Teilgebiet höchstens noch ein Modul übrig bleibt oder aber pro Teilgebiet höchstens k Module vorgesehen sind. k kann z.B. 8 sein. Beim letzteren Fall ist es erforderlich, die endgültige Anordnung der Module in einem Schritt S3 durchzuführen, bei dem eine optimale Flächenausnutzung angestrebt wird.

Im Ausführungsbeispiel der Figuren 2 bis 5 kann z.B. mit dem Schritt, der zu Figur 4 geführt hat, die Folge der Globalplazierungen und Partitionierungen abgebrochen werden und die endgültige Lage der Module, die sich aus Figur 5 ergibt, im Schritt S3 ermittelt werden.

Zu Beginn des Optimierungsschrittes S3 liegt eine Zerlegung des gegebenen Plazierungsgebietes derart vor, daß jedem Teilgebiet höchstens die vorgegebene Anzahl k von Moduln zugeordnet ist. Im Optimierungsschritt wird die Flächenausnutzung der erreichten Slicing Struktur sowohl lokal als auch global verbessert.

Zum lokalen Optimieren jedes Teilgebietes PLT mit höchstens k Moduln werden alle möglichen Zerlegungen dieses Teilgebietes bestimmt und die Moduln den entstandenen Teilflächen zugeordnet. Bei dieser Optimierung werden die Ergebnisse der Globalplazierung berücksichtigt, so daß der Aufwand für die Optimierung reduziert wird. Für jede Zerlegung und Modulzuordnung werden die Abmessungen des kleinsten rechteckigen Gebietes, in dem die Moduln überlappungsfrei plaziert werden können, durch Traversierung der Slicing Struktur berechnet. Die verschiedenen möglichen Abmessungen des gerade behandelten Teilgebietes werden in einer Formfunktion zusammengefaßt. Ein Verfahren, nach dem die Traversierung der Slicing Struktur und die Berechnung der Formfunktionen durchgeführt wird, ist aus La Potin, D.P., Director, S.W.: Mason: A global floorplanning approach for VLSI design, IEEE Transactions on Computer-Aided Design, Band CAD-5, 1986, S. 477-489 bekannt.

Im Anschluß an die lokale Flächenoptimierung werden durch geeignete Addition der Formfunktionen aller Teilgebiete global die Abmessungen aller erlaubten Modulanordnungen berechnet. Dadurch hat der Anwender die Möglichkeit, die für seine Zwecke optimale Anordnung aus den angebotenen Varianten auszuwählen.

Das Prinzip der Partitionierung ist an sich bekannt, es wird jedoch üblicherweise zum Zweck der Verringerung der Problemgröße verwendet. Beim erfindungsgemäßen Verfahren dient es jedoch dem Zweck, die Gebiete, in denen ein Modul angeordnet werden kann, zunehmend einzuschränken. Durch die fortschreitende Verfeinerung der Partitionierung wird am Verfahrensende eine überlappungsfreie Anordnung aller Module erzielt. Das Verfahren ist dabei derart, daß alle Module bis zum Erreichen der überlappungsfreien Anordnung simultan behandelt werden.

Durch mehrmalige Wiederholung der Verfahrensschritte Globalplazierung und Partitionierung und durch die simultane Arbeitsweise werden bessere Ergebnisse erzielt als durch isolierte Anwendung beider Prinzipien.

Mit Hilfe des Optimierungsschrittes wird eine optimale Flächenausnutzung erreicht, wobei die Einzelmodule in ihrer Lage auch gedreht werden.

**Patentansprüche**

1. Verfahren zur Plazierung von Modulen (M) auf einem Träger (TR) mit Hilfe eines Rechners unter Verwendung von einer die Abmessungen enthaltenden Modulliste und einer die Verbindungen enthaltenden Netzliste, mit folgenden Verfahrensschritten:

a) es werden alle beweglichen Module ($M_b$) auf dem Plazierungsgebiet (PL) des Trägers (TR) durch Globalplazierung derart angeordnet, daß der Gesamtschwerpunkt der Module auf dem Flächenschwerpunkt ($X_r$, $Y_r$) des Plazierungsgebietes liegt, und es werden alle fixierten Module ($M_f$) an den Rändern des Plazierungsgebietes angeordnet;

b) in einem Partitionierungsschritt

   b1) wird das Plazierungsgebiet (PL) in Teilgebiete (PLT) unterteilt,

   b2) dann werden aufgrund der im Schritt a) festgelegten Lage der Module diese in Teilmengen ($M_r$) von Modulen aufgeteilt und diese den Teilgebieten (PLT) zugeordnet,

   b3) anschließend wird die Größe der Teilgebiete im Verhältnis der den Teilgebieten zugeordneten Teilmengen ($M_r$) von Modulen endgültig festgelegt;

c) die Module ($M_b$) werden in einer Globalplazierung simultan für alle Teilgebiete (PLT) unter teilgebietsübergreifender gegenseitiger Beeinflussung durch die in der Netzliste enthalten Verbindungen derart angeordnet, daß die Gesamtschwerpunkte der Modulteilmengen ($M_r$) jeweils auf den Flächenschwerpunkten ($X_r$, $Y_r$) der zugeordneten Teilgebiete (PLT) liegen;

d) in einem weiteren Partitionierungsschritt

   d1) werden die Teilgebiete in weitere Teilgebiete unterteilt,

   d2) dann werden aufgrund der im Schritt c) festgelegten Lage der Module ($M_b$) diese den weiteren Teilgebieten (PLT) zugeordnet,

   d3) anschließend wird die Größe der weiteren Teilgebiete im Verhältnis der den weiteren Teilgebieten zugeordneten Module endgültig festgelegt;

e) die Schritte c) und d) werden solange wiederholt bis jedem Teilgebiet höchstens eine vorgebbare Anzahl von k Modulen zugeordnet ist.

2. Verfahren nach Anspruch 1, dadurch **gekennzeichnet,** daß die vorgegebenen Punkte des Plazierungsgebiets und der Teilgebiete jeweils deren Zentrumskoordinaten ($X_r$, $Y_r$) sind.

3. Verfahren nach Anspruch 2, dadurch **gekennzeichnet,** daß zur Globalplazierung die x, y Koordinaten der Module simultan derart festgelegt werden, daß

$$\phi(x,y) = \frac{1}{2} \sum_{n \in N} \sum_{m \in M} \left( (x_m + u_{nm} - x_n)^2 + (y_m + v_{nm} - y_n)^2 \right) \cdot t_{nm} \cdot w_n$$

ein Minimum wird und für das Plazierungsgebiet (PL) bzw. für jedes Teilgebiet (PLT) Nebenbedingungen

$$\left( \sum_{m \in M_r} F_m \cdot x_m \right) \bigg/ \left( \sum_{m \in M_r} F_m \right) = X_r \quad \text{und}$$

$$\left( \sum_{m \in M_r} F_m \cdot y_m \right) \bigg/ \left( \sum_{m \in M_r} F_m \right) = Y_r$$

für $1 \leq r \leq R$

eingehalten werden, wobei die Formelzeichen folgende Bedeutung haben:

m                      Modulnummer

n                      Netznummer

| | |
|---|---|
| M = (...,m,...) | Menge der Modulnummern |
| N = (...,n,...) | Menge der Netznummern |
| $M_b$ C M | Menge der beweglichen Moduln |
| $M_f$ C M | Menge der fixierten Moduln |
| b | Anzahl der beweglichen Moduln |
| f | Anzahl der fixierten Moduln |
| x = (...$x_n$...$x_m$...) | Vektor der x-Koordinaten aller Netze und Moduln |
| y = (...$y_n$...$y_m$...) | Vektor der y-Koordinaten aller Netze und Moduln |
| $u_{nm}$ | x-Koordinate des Anschlusses des Netzes n am Modul m |
| $v_{nm}$ | y-Koordinate des Anschlusses des Netzes n am Modul m |

$$t_{nm} = \begin{array}{c} 1 \\ \\ 0 \end{array}$$

| | |
|---|---|
| | falls Netz n am Modul m angeschlossen ist falls nicht angeschlossen |
| $w_n$ | Gewichtsfaktor des Netzes n |
| $F_m$ | Flächenbedarf des Moduls m |
| r | Nummer des Plazierungsgebiets PL oder Teilgebietes PLT |
| $M_r$ C $M_b$ | Menge der Moduln, auf die die Nebenbedingung r angewandt wird |
| $X_r$, $\overline{Y}_r$ | Zentrumskoordinaten des Plazierungsgebiets PL, PLT |
| R | Anzahl der Teilgebiete PLT |

**4.** Verfahren nach Anspruch 3,
dadurch **gekennzeichnet,**
daß die fixierten Module ($M_f$) an den Rändern des Plazierungsgebietes (PL) in x- bzw. y-Richtung verschiebbar sind.

**5.** Verfahren nach Anspruch 4,
dadurch **gekennzeichnet,**
daß die Zuweisung der Module (M) zu den Teilgebieten (PLT) durch Sortierung der Module nach deren x, y - Koordinaten erfolgt.

**6.** Verfahren nach Anspruch 5,
dadurch **gekennzeichnet,**
daß die Unterteilung des Plazierungsgebietes und der Teilgebiete durch horizontale und vertikale Schnittlinien (SL) erfolgt, und den durch die Schnitte erzielten Teilgebieten (PLT) Modulteilmengen ($M_r$) zugewiesen werden.

**7.** Verfahren nach Anspruch 6,
dadurch **gekennzeichnet,**
daß jeweils eine Zweiteilung jedes Gebietes bei der Partitionierung erfolgt.

**8.** Verfahren nach Anspruch 7,
dadurch **gekennzeichnet,**
daß Module (M), deren zugeordnete Verbindungen die Schnittlinie (SL) überschreiten, den Teilgebieten (PLT) unter zusätzlicher Anwendung des Min-Cut-Prinzips zugeordnet werden.

**9.** Verfahren nach einem der Ansprüche 1 bis 8,
dadurch **gekennzeichnet,**
daß die Globalplazierung und Partitionierung beendet wird, wenn in jedem Teilgebiet ein Modul (M) (k-1) angeordnet ist.

**10.** Verfahren nach einem der Ansprüche 1 bis 8,
dadurch **gekennzeichnet.**
daß die optimale Flächenausnutzung durch Feststellung aller möglichen Zerteilungen der Teilgebiete (PLT) mit bis zu k Modulen (M) unter Ausnutzung des Ergebnisses der Globalplazierung erfolgt.

**11.** Verfahren nach Anspruch 10,
dadurch **gekennzeichnet,**
daß die Anordnung der Module (M) in den Teilgebieten (PLT) dadurch optimiert wird, daß für jedes Teilgebiet alle möglichen Zerlegungen bestimmt und die Module den entstandenen Teilflächen zugeordnet werden, daß für jede Zerlegung und Modulzuordnung die Abmessungen des kleinsten rechteckigen Gebietes, in dem die Module überlappungsfrei plaziert werden können, berechnet werden und die verschiedenen möglichen Abmessungen einer Teilfläche in einer Formfunktion zusammengefaßt werden, und daß dies für alle Teilgebiete (PLT) durchgeführt wird und durch Addition der Formfunktionen aller Teilgebiete die Abmessungen aller erlaubten Modulanordnungen berechnet wird.

**12.** Verfahren nach Anspruch 11,
dadurch **gekennzeichnet,**
daß die Drehlagen der Moduln optimiert werden.

**Claims**

**1.** Method for placing modules (M) on a carrier (TR) with the aid of a computer and with the use of a module list containing the dimensions and of a network list containing the connections, comprising the following method steps:

a) all the movable modules ($M_b$) are arranged on the placement region (PL) of the carrier (TR) by global placement in such a way that the overall centre of gravity of the modules is situated at the area centre of gravity ($X_r$, $Y_r$) of the placement region, and all the fixed modules ($M_f$) are arranged at the edges of the placement region;

b) in a partitioning step

b1) the placement region (PL) is subdivided into subregions (PLT),

b2) on the basis of the position of the modules fixed in step a), said modules are then split into subsets ($M_r$) of modules and said subsets are assigned to the subregions (PLT),

b3) the size of the subregions is subsequently fixed in the ratio of the subsets ($M_r$) of modules assigned to the subregions;

c) the modules ($M_b$) are arranged in a global placement simultaneously for all the subregions (PLT) subject to the mutual influence, spread over the subregions, of the connections contained in the network list, in such a way that the overall centres of gravity of the module subsets ($M_r$) are situated in each case at the area centres of gravity ($X_r$, $Y_r$) of the assigned subregions (PLT);

d) in a further partition step

d1) the subregions are subdivided into further subregions,

d2) on the basis of the position of the modules ($M_b$) fixed in step c), said modules are then assigned to the further subregions (PLT),

d3) the size of the further subregions is subsequently ultimately fixed in the ratio of the modules assigned to the further subregions; and

e) steps c) and d) are repeated until at most a prescribable number of k modules are assigned to each subregion.

**2.** Method according to Claim 1, characterized in that the prescribed points of the placement region and of the subregions are respectively their centre co-ordinates ($X_r$, $Y_r$).

**3.** Method according to Claim 2, characterized in that for the purpose of global placement, the x, y coordinates of the modules are fixed simultaneously in such a way that

$$\phi(x,y) = \frac{1}{2} \sum_{n \in N} \sum_{m \in M} ((x_m + u_{nm} - x_n)^2 + (y_m + v_{nm} - y_n)^2) \cdot t_{nm} \cdot w_n$$

becomes a minimum, and that secondary conditions

10

$$\left( \sum_{m \in M_r} F_m \cdot x_m \right) \Big/ \left( \sum_{m \in M_r} F_m \right) = X_r \quad \text{and}$$

$$\left( \sum_{m \in M_r} F_m \cdot y_m \right) \Big/ \left( \sum_{m \in M_r} F_m \right) = Y_r$$

where $1 \leq r \leq R$

are observed for the placement region (PL) and, respectively, for each subregion (PLT), the symbols having the following significance:

| | |
|---|---|
| m | Module number |
| n | Network number |
| $M = (...,m,...)$ | Set of the module numbers |
| $N = (...,n,...)$ | Set of the network numbers |
| $M_b$ C M | Set of the movable modules |
| $M_f$ C M | Set of the fixed modules |
| b | Number of the movable modules |
| f | Number of the fixed modules |
| $x = (...x_n...x_m...)$ | Vector of the x-coordinates of all the networks and modules |
| $y = (...y_n...y_m...)$ | Vector of the y-coordinates of all the networks and modules |
| $u_{nm}$ | x-coordinate of the terminal of the network n at the module m |
| $v_{nm}$ | y-coordinate of the terminal of the network n at the module m |

$$t_{nm} = \begin{array}{c} 1 \\ 0 \end{array}$$

| | |
|---|---|
| | If the network n is connected to the module m |
| | If not connected |
| $w_n$ | Weighting factor of the network n |
| $F_m$ | The set surface requirement of the module m |
| r | Number of the placement region PL or of the subregion PLT |
| $M_r$ C $M_b$ | Set of modules to which the secondary condition r is applied |
| $X_r, \overline{Y}_r$ | Centre coordinates of the placement region PL, PLT |
| R | Number of the subregions PLT |

4.  Method according to Claim 3, characterized in that the fixed modules ($M_f$) can be displaced in the x-direction and y-direction respectively, at the edges of the placement region (PL).

5.  Method according to Claim 4, characterized in that the assignment of the modules (M) to the subregions (PLT) is performed by sorting the modules according to their x, y coordinates.

6.  Method according to Claim 5, characterized in that the subdivision of the placement region and of the subregions is performed by horizontal and vertical intersection lines (SL) and module subsets ($M_r$) are assigned to the subregions (PLT) achieved by the sections.

7.  Method according to Claim 6, characterized in that in partitioning a bipartitioning of each region is performed in each case.

8.  Method according to Claim 7, characterized in that modules (M) whose assigned connections transgress the intersection line (SL) are assigned to the subregions (PLT) with the additional application of the min-cut principle.

9. Method according to one of Claims 1 to 8, characterized in that the global placement and partitioning are ended when one module (M) (k-1) is arranged in each subregion.

10. Method according to one of Claims 1 to 8, characterized in that the optimum area utilization is performed by determining all the possible divisions of the sub-regions (PLT) having up to k modules (M) by utilizing the result of the global placement.

11. Method according to Claim 10, characterized in that the arrangement of the modules (M) in the subregions (PLT) is optimized by determining all the possible splits for each subregion and assigning the modules with the sub-areas produced, by calculating for each split and module assignment the dimensions of the smallest rectangular region in which the modules can be placed free from overlap and combining the various possible dimensions of a sub-area in a form function, and by carrying out this for all the subregions (PLT) and calculating the dimensions of all the permissible module arrangements by adding the form functions of all the subregions.

12. Method according to Claim 11, characterized in that the rotational positions of the modules are optimized.

**Revendications**

1. Procédé pour mettre en place des modules (M) sur un support (T1) à l'aide d'un ordinateur et moyennant l'utilisation d'une liste de modules contenant les dimensions, et d'une liste de réseaux contenant les liaisons, par la mise en oeuvre des étapes opératoires suivantes :

   a) on dispose selon une mise en place globale, tous les modules mobiles ($M_b$) dans la zone de mise en place (PL) du support (TR) de telle sorte que le centre de gravité global des modules est situé au niveau du barycentre ($X_r$, $Y_r$) de la surface de la zone de mise en place, et on dispose tous les modules fixés ($M_f$) sur les bords de la zone de mise en place;

   b) lors d'une étape de séparation

   b1) on subdivise la zone de mise en place (PL) en zones partielles (PLT),

   b2) ensuite, sur la base de la position des modules fixée lors de l'étape a), on répartit ces modules en des quantités partielles ($M_r$) de modules et on associe ces quantités partielles aux zones partielles (PLT),

   b3) ensuite, on fixe de façon définitive la taille des zones partielles dans le rapport des quantités partielles ($M_r$) des modules, associées aux zones partielles;

   c) on dispose simultanément les modules ($M_b$), au moyen d'une mise en place globale, pour toutes les zones partielles (PLT), sous l'influence réciproque, avec chevauchement de zones partielles, au moyen des liaisons contenues dans la liste de réseaux de telle sorte que les centres de gravité globaux des quantités partielles $M_r$ de modules sont situés respectivement au niveau des barycentres ($X_r$, $Y_r$) des surfaces des zones partielles associées (PLT);

   d) lors d'une autre étape de séparation

   d1) on divise les zones partielles en d'autres zones partielles,

   d2) ensuite, et sur la base de la position des modules ($M_b$) fixée lors de l'étape c), on associe ces modules aux autres zones partielles (PLT),

   d3) on fixe ensuite de façon définitive la taille des autres zones partielles dans le rapport des modules associés aux autres zones partielles;

   e) on répète les étapes c) et d) jusqu'à ce qu'un nombre, pouvant être prédéterminé, de k modules soit associé à chaque zone partielle.

2. Procédé suivant la revendication 1, caractérisé par le fait que les points prédéterminés de la zone de mise en place et des zones partielles sont respectivement les coordonnées ($X_r$, $Y_r$) de leurs centres.

3. Procédé suivant la revendication 2, caractérisé par le fait que pour la mise en place globale, les coordonnées (x, y) des modules sont fixées simultanément de telle sorte que l'on a

$$\Phi(x, y) = -\frac{1}{2} \sum_{n \in N} \sum_{m \in M} ((x_m + u_{nm} - x_n)^2 + (y_m + v_{nm} - y_n)^2) \cdot t_{nm} \cdot w_n$$

deviennent minimum et que pour la zone de mise en place (PL) ou pour chaque zone partielle (PLT), on respecte des conditions secondaires

$$(\sum_{m \in M_r} F_m \cdot x_m) / (\sum_{m \in M_r} F_m) = X_r \quad \text{et}$$

$$(\sum_{m \in M_r} F_m \cdot y_m) / (\sum_{m \in M_r} F_m) = Y_r \quad \text{et}$$

pour $1 \leq r \leq R$

des symboles dans les formules ayant les significations suivantes :

| | |
|---|---|
| $m$ | numéro de module |
| $n$ | numéro de réseau |
| $M = (...,m,...)$ | quantité des numéros de modules |
| $N = (...,n,...)$ | quantité des numéros de réseaux |
| $M_b \subset M$ | quantité des modules mobiles |
| $M_f \subset M$ | quantité des modules fixés |
| $b$ | nombre des modules mobiles |
| $f$ | nombre des modules fixés |
| $x = (...x_n...x_m...)$ | vecteur des coordonnées x de tous les réseaux et de tous les modules |
| $y = (...x_n...x_m...)$ | vecteur des coordonnées y de tous les réseaux et de tous les modules |
| $u_{nm}$ | coordonnée x de la borne du réseau n au niveau du module m |
| $v_{nm}$ | coordonnée y de la borne du réseau m au niveau du module m |

$$t_{nm} = \begin{matrix} 1 \\ 0 \end{matrix}$$

| | |
|---|---|
| | dans le cas où le réseau n est raccordé au module m |
| | dans le cas où il n'y a aucun raccordement |
| $w_n$ | facteur pondéral du réseau n |
| $F_m$ | besoin en surface du module m |
| $r$ | numéro de la zone de mise en place PL ou de la zone partielle PLT |
| $m_r \subset M_b$ | quantité des modules, à laquelle est appliquée la condition secondaire r |
| $X_r, Y_r$ | coordonnées du centre de la zone de mise en place PL, PLT |
| $R$ | nombre des zones partielles PLT. |

4. Procédé suivant la revendication 3, caractérisé par le fait que les modules fixés ($M_f$) sont déplaçables dans la direction x et dans la direction y au niveau des bords de la zone de mise en place (PL).

5. Procédé suivant la revendication 4, caractérisé par le fait que l'affectation des modules (M) aux zones partielles (PLT) s'effectue au moyen du tri des modules en fonction de leurs coordonnées (x, y).

6. Procédé suivant la revendication 5, caractérisé par le fait que la division de la zone de mise en place et des zones partielles est réalisée par des lignes de coupe horizontales et verticales (SL), et que des quantités partielles de modules ($M_r$) sont affectées aux zones partielles (PLT) déterminées par les coupes.

13

**7.** Procédé suivant la revendication 6, caractérisé par le fait que lors de la division, chaque zone est respectivement divisée par deux.

**8.** Procédé suivant la revendication 7, caractérisé par le fait que des modules (M), dont les liaisons associées croisent la ligne de coupe (SL), sont associés aux zones partielles (PLT) moyennant l'application supplémentaire du principe Min-Cut.

**9.** Procédé suivant l'une des revendications 1 à 8, caractérisé par le fait qu'on arrête la mise en place globale et la division lorsqu'un module (M) (k-1) est disposé dans chaque zone partielle.

**10.** Procédé suivant l'une des revendications 1 à 8, caractérisé par le fait que l'utilisation optimale de la surface est obtenue par détermination de toutes les fragmentations possibles des zones partielles (PLT) avec jusqu'à k modules (M) moyennant l'utilisation du résultat de la mise en place globale.

**11.** Procédé suivant la revendication 10, caractérisé par le fait que la disposition des modules (M) dans les zones partielles (PLT) est optimisée par le fait que pour chaque zone partielle on détermine toutes les divisions possibles et qu'on associe les modules aux surfaces partielles obtenues, que pour chaque division et chaque association de modules, on peut calculer les dimensions de la zone rectangulaire la plus petite, dans laquelle les modules peuvent être placés sans chevauchement, et on rassemble les différentes dimensions possibles d'une surface partielle dans une fonction de forme, et qu'on effectue ceci pour toutes les zones partielles (PLT) et qu'on calcule les dimensions de tous les ensembles obtenus de modules, par addition des fonctions de forme de toutes les zones partielles.

**12.** Procédé suivant la revendication 11, caractérisé par le fait qu'on optimise les positions pivotées des modules.

# FIG 1

# FIG 6

FIG 2

FIG 3

**FIG 4**

**FIG 5**

## FIG 7

**Anfang**

**Initialisierung** $S0$

Ordne alle beweglichen Moduln einem ungeteilten Plazierungsgebiet mit gegebener Fläche zu.

Eine Nebenbedingung fixiert den Schwerpunkt aller Moduln.

**Wiederhole**

**Globalplazierung** $S1$

Bestimme eine *optimale* Globalplazierung *simultan* für alle Moduln unter Einhaltung der Nebenbedingungen für jedes Teilgebiet.

Ziel: Minimiere die Summe der quadrierten Längen der Signale

**Partitionierung** $S2$

Partitioniere alle Gebiete, die mehr als $k$ Moduln enthalten, d.h. teile ihre Modulmengen und die zugehörigen rechteckigen Bereiche.

Stelle die Nebenbedingungen für die nächste Globalplazierung auf.

bis jedes Gebiet höchstens $k$ Moduln enthält

**Optimierung** $S3$

Optimiere die Flächenausnutzung durch Enumeration aller möglichen Zerteilungen für Gebiete mit bis zu $k$ Moduln unter Ausnutzung des Ergebnisses der Globalplazierung.

**Ende**